# EUROPEAN PATENT SPECIFICATION

(11) **EP 1 011 199 B1**
(45) Date of publication and mention of the grant of the patent: **03.12.2003**
(21) Application number: 99124356.9
(22) Date of filing: 07.12.1999
(51) Int. Cl.: H03M 1/00, G01N 25/64

(54) **Device and method for detecting humidity**
Apparat und Verfahren zur Feststellung der Feuchtigkeit
Appareil et méthode pour la détection de l'humidité

(30) Priority: 14.12.1998 JP 35418398
(43) Date of publication of application: 21.06.2000
(73) Proprietor: MATSUSHITA ELECTRIC INDUSTRIAL CO., LTD., Kadoma-shi, Osaka (JP)
(72) Inventor: Nishihara, Yoshikazu, Kouka-gun, Shiga 529-1851 (JP); Takahara, Tsutomu, Moriyama-shi, Shiga 524-0022 (JP); Marumo, Toshio, Kusatsu-shi, Shiga 525-0027 (JP); Unida, Hiroyuki, Kusatsu-shi, Shiga 525-0045 (JP)
(74) Representative: Eisenführ, Speiser & Partner

(56) References cited:
- EP-A- 0 729 234
- US-A- 4 381 496
- PATENT ABSTRACTS OF JAPAN vol. 1997, no. 01, 31 January 1997 (1997-01-31) -& JP 08 247985 A (NGK SPARK PLUG CO LTD), 27 September 1996 (1996-09-27)

## Description

### BACKGROUND OF THE INVENTION

The present invention relates to a technique for detecting the humidity of the air, and more particularly to a humidity sensing technique suitably used for air conditioners.

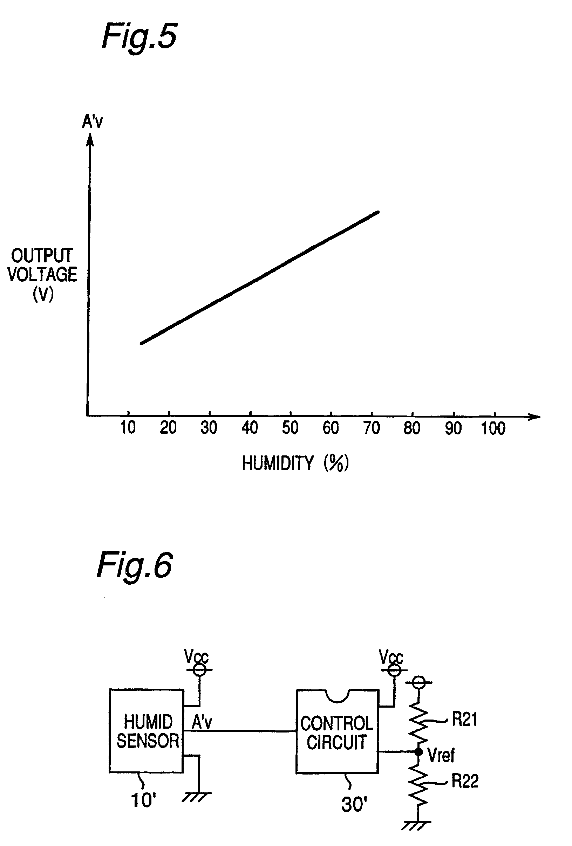

Conventionally, humidity sensors for sensing the humidity which indicates the amount of moisture in the air are known. Such humidity sensors generally output a voltage corresponding to the humidity. Fig. 5 is a graph showing the output characteristic of a conventional humidity sensor. In Fig. 5, the horizontal axis represents the humidity of the air and the vertical axis represents the output voltage of the humidity sensor. As is observed from this figure, the conventional humidity sensor outputs a voltage which sequentially changes with a change of the humidity

Humidity sensors as described above are used for various electric appliances. Typically, they are used for air conditioners for controlling the temperature and humidity of the air indoor. As shown in Fig. 6, such an electric appliance includes a control circuit 30' (e.g., a microprocessor) for controlling the operation of the electric appliance. The control circuit 30' performs predetermined control on various circuits of the electric appliance based on the humidity detected by a humidity sensor 10'. More specifically, the control circuit 30' converts an analog voltage output from the humidity sensor 10' to a digital value based on an analog reference voltage Vref (hereinafter, this conversion is referred to as "A/D conversion"), and determines the humidity based on the digital value. The analog reference voltage Vref represents the maximum value of the analog voltage for the A/D conversion. For example, when the analog voltage is to be converted to an 8-bit digital value (00 to FF), the analog reference voltage Vref indicates the analog voltage corresponding to the digital value FF. The analog reference voltage Vref is obtained by dividing a power supply voltage Vcc using a serial circuit composed of resistors R21 and R22.

The humidity sensor 10' itself has a detection error of about ±5%. The control circuit 30' also generates an error during the A/D conversion, which includes a conversion error (about ±1 bit) due to a quantum error generated when the analog voltage is converted to a digital value, as well as variations in the values of the resistors R21 and R22 which provide the analog reference voltage Vref, a variation in the power supply voltage Vcc, and the like. Summing these errors, the conventional humidity sensor has a detection error of about 10% as a whole, resulting in a failure in obtaining high-precision humidity detection. This causes a problem that when humidity-based control is performed in an electric appliance using such a humidity sensor, the precision of the control is degraded. For an air conditioner, in particular, since the air conditioner needs various types of control based on the humidity in order to create a more comfortable air-conditioning environment, it is important to detect the humidity as precisely as possible.

In the patent abstract of Japan JP-A-08/247985 a humidity detector circuit for measuring relative humidity is described. The humidity detector circuit transforms the information about the relative humidity according to a humidity sensor into a pulse width signal. The width of the pulses is proportional to the humidity. A smoothing circuit smoothes the width proportional to the humidity, and converts it to an analogue voltage signal.

### SUMMARY OF THE INVENTION

The object of the present invention is to provide a humidity detection device and method capable of realizing high detection precision and especially suitable for use in the air conditioner.

According to the present invention this object is achieved by a device for detecting humidity comprising a sensing section which outputs a first voltage A'v which continuously changes with a change of the humidity of the air, wherein a step-output circuit which converts the first voltage A'v output from the sensing section to a second voltage Av which changes stepwise, whereby each step corresponds to a predetermined voltage range.

The device further may comprise a decision unit which receives the voltage output from the step output section and determines the level of the received voltage to decide the humidity. The device may be incorporated in an air conditioner to detect an indoor humidity.

A method according to the present invention for detecting humidity contains the steps of obtaining a first voltage A'v which continuously changes with a change of the. humidity in the air and the step of generating a second voltage Av which changes stepwise from the first voltage A'v, wherein each step corresponds to a predetermined voltage range; and determining the level of the second voltage Av to decide the humidity.

According to the humidity detection device of the present invention, a voltage is output, which changes stepwise with a change of the humidity of the air. A control circuit which performs predetermined humidity-based control determines the level of the voltage output from the humidity detection device and thus decides the humidity. Thus a conversion error due to a quantum error, a variation in the power supply voltage and the like during A/D conversion can be eliminated. In this way, high-precision humidity detection is realized. In particular, when the humidity detection device is incorporated in an indoor component of an air conditioner, the indoor humidity can be detected with high precision. This realizes high-precision humidity-based control and thus creation of a more comfortable air-conditioning environment. The humidity detection method according to the present invention can also provides substantially the same effect.

Other features and advantages of the invention will become apparent to those skilled in the art from the description of the preferred embodiments.

### BRIEF DESCRIPTION OF THE DRAWINGS

Fig. 1 is a structural view of a humidity sensor according to the present invention.
Fig. 2 is a graph showing the output characteristic of a sensor section.
Fig. 3 is a graph showing the output characteristic of the humidity sensor according to the present invention.
Fig. 4 is a flowchart of a humidity determination processing for a control circuit.
Fig. 5 is a graph showing the output characteristic of a conventional humidity sensor.
Fig. 6 is a structural view illustrating a conventional humidity sensor and a control circuit which performs predetermined control using the detection results from the humidity sensor.

### DETAILED DESCRIPTION OF THE PREFERRED EMBODIMENTS

Hereinafter, the humidity sensor according to the present invention will be described by way of an example with reference to the accompanying drawings.

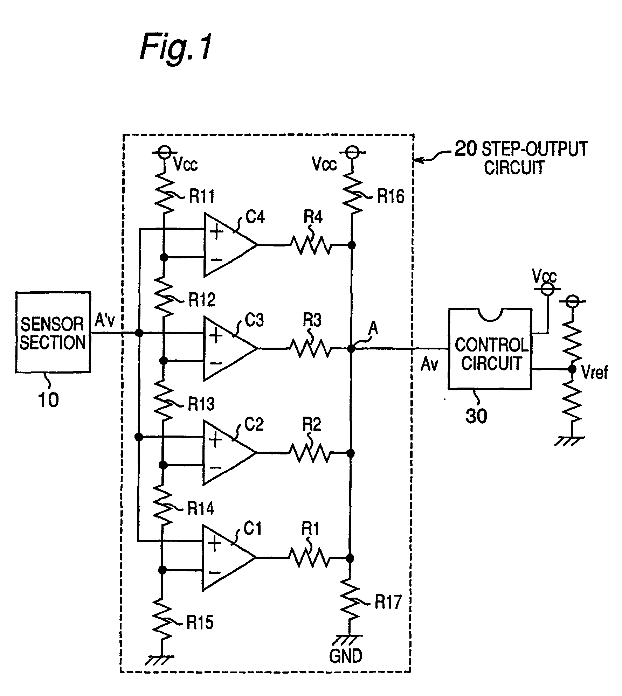

Fig. 1 shows a structure of a humidity sensor according to the present invention. The humidity sensor includes a sensor section 10 which converts the humidity of the air to a voltage and a step-output circuit 20 which converts the voltage output from the sensor section 10 to a voltage which changes stepwise every predetermined voltage range. The output of the humidity sensor is input into a control circuit 30 which comprises a microprocessor, for example. Such a humidity sensor and the control circuit 30 are normally incorporated in an electric appliance. The control circuit 30 controls respective components of the electric appliance in a predetermined manner.

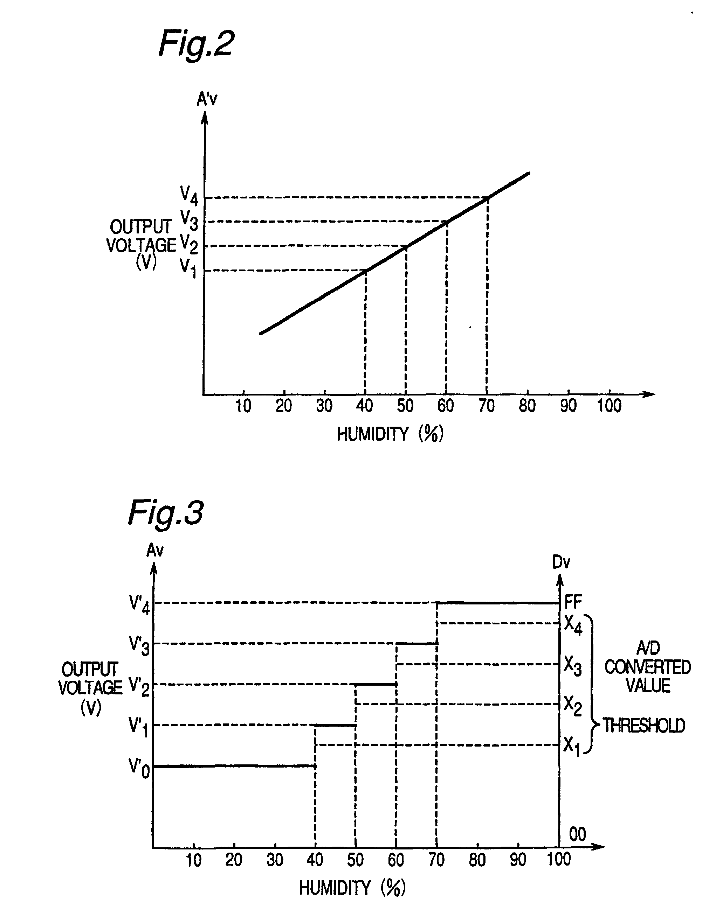

The sensor section 10 is a circuit for sensing humidity comprising a humidity sensing element, and has substantially the same output characteristic as the conventional humidity sensor. That is, the sensor section 10 outputs an analog voltage A'v which sequentially or linearly changes with a change of the humidity of the air as shown in Fig. 2. In Fig. 2, the output voltages A'v of the sensor section 10 obtained when the humidity is 40%, 50%, 60%, and 70% are specifically denoted by V1, V2, V3, and V4, respectively.

The step-output section 20 receives the voltage A'v output from the sensor section 10, converts the voltage A'v to a voltage Av which changes stepwise every predetermined voltage range as shown in Fig. 3, and outputs the converted voltage Av. Referring to Fig. 1, the step-output section 20 includes comparators C1, C2, C3 and C4, resistors R1 to R4 and R11 to R17. The resistors R1, R2, R3 and R4 are connected to the output terminals of the corresponding comparators C1, C2, C3 and C4. The resistors R11, R12, R13, R14 and R15 constitute a serial circuit to provide reference voltages to the comparators C1, C2, C3 and C4 respectively. The resistors R16 and R17 contribute to the output voltage of the humidity sensor.

Each comparator C1, C2, C3 or C4 receives the respective reference voltages at their negative input terminals (-) and the voltage A'v output from the sensor section 10 at their positive input terminals (+). The reference voltages are obtained by dividing a power supply voltage Vcc through the serial circuit comprising the resistors R11, R12, R13, R14 and R15. The resistors R1, R2, R3 and R4 are connected at the other terminals to a node A at which the resistors R16 and R17 are connected with each other. The voltage at the node A is obtained as the output voltage Av of the humidity sensor to be fed into the control circuit 30.

The output of each comparator C1, C2, C3 or C4 is controlled in the following manner. The output terminal is held at a ground potential when the voltage of the positive input terminal is lower than that of the negative input terminal, and the output terminal is controlled to be open when the voltage of the positive input terminal is equal to or higher than that of the negative input terminal. In this example, the reference voltage for each comparator C1, C2, C3 or C4 is set to be equal to the voltages V1, V2, V3 or V4 output from the sensor section 10 when the humidity is 40%, 50%, 60% or 70%, respectively. Such reference voltage supplied to the comparator C1, C2, C3 or C4 can be determined by appropriately selecting the values of the resistors R11, R12, R13, R14 and R15.

When the voltage A'v output from the sensor section 10 is equal to or higher than the respective reference voltage for the comparator C1, C2, C3 or C4, the resistor R1, R2, R3 or R4 connected to the comparator C1, C2, C3 or C4 is put in a floating state. Meanwhile, when the output voltage A'v is lower than the respective reference voltage, one terminal of the each resistor R1, R2, R3 or R4 are grounded. As a result, when the output voltage A'v is lower than V1, a parallel circuit comprising the resistors R1, R2, R3, R4 and R17 is formed between the node A and the ground GND. Likewise, when the output voltage A'v is a value between V1 and V2, a parallel circuit comprising the resistors R2, R3, R4 and R17 is formed between the node A and the ground GND. In this way, as the voltage A'v output from the sensor section 10 increases to reach the voltages V1, V2, V3, and V4, the number of resistors constituting the parallel circuit formed between the node A and the ground GND is reduced, increasing the resistance value of the entire parallel circuit. As a result, the voltage at the node A increases stepwise.

Conventionally, a humidity sensor outputs a voltage which sequentially changes in proportion to the humidity as shown in Fig. 5. Meanwhile, the humidity sensor according to the invention outputs a voltage which changes stepwise with a change of the humidity every predetermined voltage range as shown in Fig. 3. Specifically, as shown in Fig. 3, a voltage V'0 is output when the humidity is lower than 40%, a voltage V'1 is output when the humidity is in the range of 40% to 50%, a voltage V'2 is output when the humidity is in the range of 50% to 60%, a voltage V'3 is output when the humidity is in the range of 60% to 70%, and a voltage V'4 is output when the humidity is 70% or higher. In this regard, it is also possible to express that the humidity sensor of this invention detects the humidity every predetermined humidity range.

In this embodiment, the humidity range for the stepwise change of the output voltage is set by 10%. The range is not limited to this, but any range may be used.

Next, the operation of the control circuit 30 which determines the humidity based on the output of the humidity sensor described above will be described.

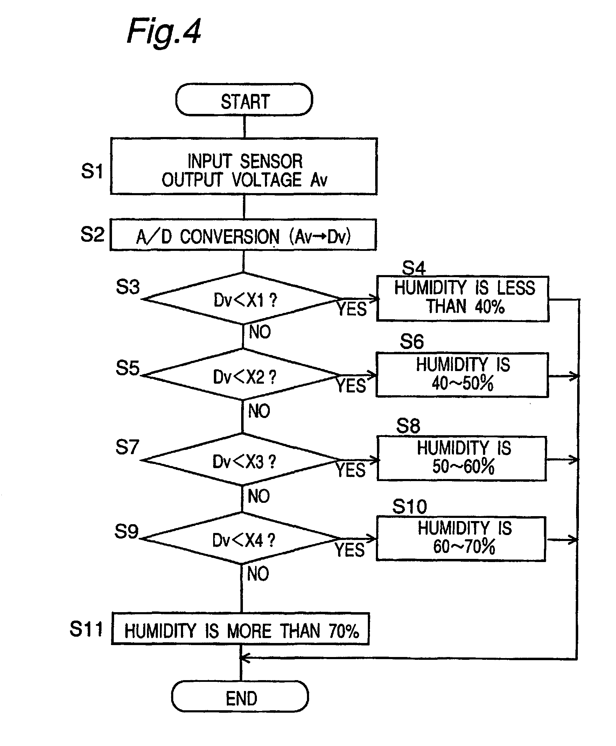

Fig. 4 is a flowchart showing a humidity determination processing for the control circuit 30. Referring to Fig. 4, the control circuit 30 receives the analog voltage Av output from the humidity sensor (the step-output circuit 20) (S1) and converts the received voltage to a digital value Dv (A/D conversion) (S2). The control circuit 30 then compares the digital value Dv with some predetermined levels (thresholds X1, X2, X3 and X4) to determine the humidity range.

Here, the threshold X1, X2, X3 or X4 for determination of the humidity range will be described. The threshold X1 is set at a value between values obtained by A/D conversion of the voltages V'0 and V'1. The threshold X2 is set at a value between values obtained by A/D conversion of the voltages V'1 and V'2. The threshold X3 is set at a value between values obtained by A/D conversion of the voltages V'2 and V'3. The threshold X4 is set at a value between values obtained by A/D conversion of the voltages V'3 and V'4. The threshold X1, X2, X3 or X4 is respectively set at values having a sufficient margin from the A/D converted value of the voltage V'1, V'2, V'3 or V'4. Thus, when an error is generated due to a variation in the power supply voltage Vcc and the like during the A/D conversion of the voltage V'1, V'2, V'3 or V'4, the error can be absorbed by the margin, allowing for the humidity determination free from influence of the variation.

Returning to Fig. 4, after the step S2, it is determined whether or not the digital value Dv is smaller than the threshold X1 (S3). When the digital value Dv is smaller than the threshold X1, the humidity is decided to be less than 40% (S4), and the processing is terminated. When the digital value Dv is not smaller than the threshold X1, the processing proceeds to step S5.

At step S5, it is determined whether or not the digital value Dv is smaller than the threshold X2. When the digital value Dv is smaller than the threshold X2, the humidity is decided to be in the range of 40% to 50% (S6), and the processing is terminated. When the digital value Dv is not smaller than the threshold X2, the processing proceeds to step S7.

At step S7, it is determined whether or not the digital value Dv is smaller than the threshold X3. When the digital value Dv is smaller than the threshold X3, the humidity is decided to be in the range of 50% to 60% (S8), and the processing is terminated. When the digital value Dv is not smaller than the threshold X3, the processing proceeds to step S9.

At step S9, it is determined whether or not the digital value Dv is smaller than the threshold X4. When the digital value Dv is smaller than the threshold X4, the humidity is decided to be in the range of 60% to 70% (S10), and the processing is terminated. When the digital value Dv is not smaller than the threshold X4, the humidity is decided to be 70% or more (S11).

The control circuit 30 determines the humidity (humidity range) using the output of the humidity sensor in the above-described manner, and thereafter performs predetermined control for the electric appliance based on the determined humidity range.

As described above, the control circuit 30 determines the humidity by comparing detected values output from the humidity sensor with predetermined thresholds. Those thresholds are set at values having a sufficient margin from the detected values output from the humidity sensor. Thus, when a conversion error is generated due to a variation in the power supply voltage Vcc, a variation in the reference resistance value and the like during the A/D conversion of the detected values, the resultant humidity determination will not be influenced by such an error. Therefore, the influence of an error generated in the control circuit 30 during A/D conversion can be eliminated and only an error generated in the sensor section 10 influences the detection precision, and the detection precision can be improved as a whole.

The humidity sensor described above may be incorporated in an indoor component of an air conditioner. For example, the indoor humidity detected by the humidity sensor can be used, together with other factors such as the indoor temperature detected by another sensor (the temperature of the air sucked into the indoor component) or the temperature in a piping (the refrigerant temperature), for the control of the indoor and outdoor components. This realizes higher precision in the humidity-based control required for the air conditioner.

## Claims

1. A device for detecting humidity comprising
a sensing section (10) which outputs a first voltage (A'v) which continuously changes with a change of the humidity of the air, **characterized by**
a step-output circuit (20) which converts the first voltage (A'v) output from the sensing section (10) to a second voltage (Av) which changes stepwise, whereby each step corresponds to a predetermined voltage range.

2. The device according to claim 1 **characterized in that** the step-output circuit (20) comprises a plurality of comparators (C1-C4) each having a different reference voltage, and a plurality of resistors (R1-R4) each coupled. at one end to output of the respective comparator and coupled at the other end to an output node (A) of the step-output circuit.

3. The device according to claim 1 **characterized in that** a decision unit (30) receives the voltage output from the step-output circuit and determines the level of the received voltage to decide the humidity.

4. The device according to any one of claim 1 to claim 3 **characterized in that** the device is incorporated in an air conditioner to detect indoor humidity.

5. A method for detecting humidity comprising the step of
obtaining a first voltage (A'v) which continuously changes with a change of the humidity of the air, **characterized** the steps of:
generating a second voltage (Av) which changes stepwise from the first voltage (A'v), each step corresponding to a predetermined voltage range; and
determining the level of the second voltage (Av) to decide the humidity.

## Patentansprüche

1. Vorrichtung zum Erfassen von Feuchtigkeit, mit
einem Meßabschnitt (10), welcher eine erste Spannung (A'v) ausgibt, welche sich kontinuierlich mit einer Veränderung der Luftfeuchtigkeit ändert,
**gekennzeichnet durch**
eine Stufen-Ausgabeschaltung (20), welche die erste von dem Meßabschnitt (10) ausgegebene Spannung (A'v) in eine zweite Spannung (Av) umwandelt, welche sich stufenweise ändert, wobei jede Stufe einem vorbestimmten Spannungsbereich entspricht.

2. Vorrichtung nach Anspruch 1, **dadurch gekennzeichnet, daß**
die Stufen-Ausgabeschaltung (20) eine Vielzahl von Komparatoren (C1-C4), welche jeweils eine unterschiedliche Referenzspannung aufweisen, und eine Vielzahl von Widerständen (R1-R4) aufweist, welche jeweils an einem Ende mit dem Ausgang des entsprechenden Komparators und an dem anderen Ende mit dem Ausgangsknoten (A) der Stufen-Ausgabeschaltung gekoppelt ist.

3. Vorrichtung nach Anspruch 1, **dadurch gekennzeichnet, daß**
eine Entscheidungseinheit (30) die von der Stufen-Ausgabeschaltung ausgegebene Spannung empfängt und den Pegel der empfangenen Spannung bestimmt, um die Feuchtigkeit zu ermitteln.

4. Vorrichtung nach einem der Ansprüche 1 bis 3, **dadurch gekennzeichnet, daß**
die Vorrichtung in einer Klimaanlage eingebaut ist, um die Innenfeuchtigkeit zu erfassen.

5. Verfahren zum Erfassen von Feuchtigkeit, mit den Schritten:
Erhalten einer ersten Spannung (A'v), welche sich kontinuierlich mit einer Veränderung der Luftfeuchtigkeit ändert,
**gekennzeichnet durch** den Schritt
Erzeugen einer zweiten Spannung (Av), welche sich stufenweise von der ersten Spannung (A'v) ändert, wobei jede Stufe einem vorbestimmten Spannungsbereich entspricht, und
Bestimmen eines Pegels der zweiten Spannung (Av), um die Feuchtigkeit zu ermitteln.

## Revendications

1. Dispositif pour la détection de l'humidité comprenant
une partie de détection (10) qui émet une première tension (A'v) qui se modifie constamment avec une modification de l'humidité de l'air, **caractérisé par**
un circuit d'émission par échelon (20) qui convertit la première tension (A'v) émise par la partie de détection (10) en une seconde tension (Av) qui se modifie par échelon, dans lequel chaque échelon correspond à une plage de tension prédéterminée.

2. Dispositif selon la revendication 1 **caractérisé en ce que** le circuit d'émission par échelon (20) comprend une pluralité de comparateurs (C1-C4) chacun doté d'une tension de référence différente, et une pluralité de résistors (R1-R4) chacun couplé à une extrémité à la sortie du comparateur respectif et couplé à l'autre extrémité à un noeud d'émission (A) du circuit d'émission par échelon.

3. Dispositif selon la revendication 1 **caractérisé en ce qu'**une unité décisionnelle (30) reçoit l'émission de tension depuis le circuit d'émission par échelon et détermine le niveau de la tension reçue pour décider de l'humidité.

4. Dispositif selon l'une quelconque des revendications 1 à 3 **caractérisé en ce que** le dispositif est intégré dans un conditionneur d'air pour détecter l'humidité ambiante.

5. Procédé pour la détection de l'humidité comprenant l'étape de
obtention d'une première tension (A'v) qui se modifie constamment avec une modification de l'humidité de l'air, **caractérisée par** les étapes consistant à :
générer une seconde tension (Av) qui se modifie par échelon depuis la première tension (A'v), chaque échelon correspondant à une plage de tension prédéterminée ; et
déterminer le niveau de la seconde tension (Av) pour décider de l'humidité.
